# EUROPÄISCHE PATENTSCHRIFT

(11) **EP 1 358 676 B1**
(45) Veröffentlichungstag und Bekanntmachung des Hinweises auf die Patenterteilung: **02.04.2008**
(21) Anmeldenummer: 02714001.1
(22) Anmeldetag: 08.02.2002
(51) Int. Cl.: H01L 23/66, H01L 23/58

(54) **ABSCHIRMVORRICHTUNG FÜR INTEGRIERTE SCHALTUNGEN**
SCREENING DEVICE FOR INTEGRATED CIRCUITS
DISPOSITIF DE BLINDAGE POUR CIRCUITS INTEGRES

(30) Priorität: 08.02.2001 DE 10105725
(43) Veröffentlichungstag der Anmeldung: 05.11.2003
(73) Patentinhaber: Infineon Technologies AG, 81669 München (DE)
(72) Erfinder: AUMÜLLER, Christian, 82362 Weilheim (DE); JANKE, Marcus, 81539 München (DE); HOFREITER, Peter, 83624 Otterfing (DE)
(74) Vertreter: Epping - Hermann - Fischer
(86) Internationale Anmeldenummer: PCT/DE2002/000470
(87) Internationale Veröffentlichungsnummer: WO 2002/063687

(56) Entgegenhaltungen:
- WO-A-99/16131
- US-A- 5 424 235
- DATABASE WPI Section EI, Week 200138 Derwent Publications Ltd., London, GB; Class U11, AN 2001-365175 XP002236865 (HYUNDAI ELECTRONICS IND CO LTD), 15. Juli 2000 (2000-07-15) -& US 2002/040998 A1 (HYUNDAI ELECTRONICS IND CO LTD) 11. April 2002 (2002-04-11)

## Beschreibung

Die vorliegende Erfindung betrifft eine Abschirmvorrichtung, mit der ein wirksamer Schutz gegen Angriffe auf eine integrierte Schaltung erreicht wird.

Bei integrierten Schaltungen in sicherheitsrelevanten Anwendungsbereichen tritt die Schwierigkeit auf, dass die Schaltungen gegen Angriffe zum Ausspionieren oder Analysieren der betreffenden Schaltung, z. B. mittels FIB (Focused Ion Beam), geschützt werden müssen. Auch optische oder mechanische Analysemethoden werden angewandt.

Es bestehen bereits eine Anzahl von Sicherheitskonzepten, mit denen die integrierten Schaltungen gegen derartige Angriffe geschützt, insbesondere mit einem Schutzschirm versehen werden können. Besonders wirkungsvoll ist dabei ein aktiver Schutzschirm (active shield), bei dem stromführende Leiterbahnen und/oder aktive Bauelemente eingesetzt werden, um einen äußeren Angriff auf die Schaltung abzuschirmen. Bisher wurde die Gefahr einer Analyse der Schaltungen von der Rückseite des Halbleiterchips, d. h. durch das Halbleitersubstrat hindurch, vernachlässigt.

In der Halbleitertechnologie wird vielfach ein so genanntes SOI-Substrat (Silicon On Insulator) verwendet. Es besteht im Volumen größtenteils aus einer Bulk-Siliziumschicht, auf der sich, durch eine dünne Isolatorschicht von der Bulk-Siliziumschicht getrennt, eine dünne, in der Regel kristalline Body-Siliziumschicht befindet, in der die Halbleiterbauelemente ausgebildet sind.

In der US 5 424 235 ist ein Halbleiterspeicher beschrieben, bei dem die Bitleitungen substratseitig zwischen Siliziumdioxidschichten angeordnet sind. Zwischen dem Substrat und den Bitleitungen befindet sich eine Abschirmelektrode mit jeweiligen Fortsetzungen, die nach oben zwischen die Bitleitungen ragen. Die Abschirmelektrode ist über Durchkontaktierungen durch eine oberseitige Isolationsschicht mit Komponenten der Speicherzellen verbunden.

Aufgabe der vorliegenden Erfindung ist es, einen wirksamen Schutz gegen Angriffe auf integrierte Schaltungen von der Substratrückseite her anzugeben.

Diese Aufgabe wird mit der Abschirmvorrichtung für integrierte Schaltungen mit den Merkmalen des Anspruchs 1 gelöst. Ausgestaltungen ergeben sich aus den abhängigen Ansprüchen.

Die erfindungsgemäße Abschirmvorrichtung umfasst Mittel zur optischen und/oder elektrischen Abschirmung, die auf der dem Substrat zugewandten Seite der integrierten Schaltung in dem Halbleiterchip angeordnet sind. Bevorzugte Ausgestaltungen verwenden ein SOI-Substrat, um die integrierte Schaltung in der Body-Siliziumschicht des SOI-Substrates auszubilden und die Isolatorschicht des SOI-Substrates als optische Abschirmvorrichtung von der Bulk-Siliziumschicht her zu nutzen.

Weiterbildungen der Erfindung sehen vor, in der Bulk-Siliziumschicht eines SOI-Substrates, vorzugsweise in der Nähe der Isolatorschicht, elektrische Leiter, insbesondere Leiterbahnen oder Leiterflächen, als Abschirmvorrichtung vorzusehen. Diese Leiter können mit einer oder mehreren Durchkontaktierungen, die durch die Isolationsschicht hindurch in die Body-Siliziumschicht geführt sind, mit der Body-Siliziumschicht oder einem oder mehreren in der Body-Siliziumschicht vorhandenen Bauelementen der Schaltung verbunden sein. So kann eine aktive Ansteuerung der in der Bulk-Siliziumschicht angeordneten Leiter realisiert sein.

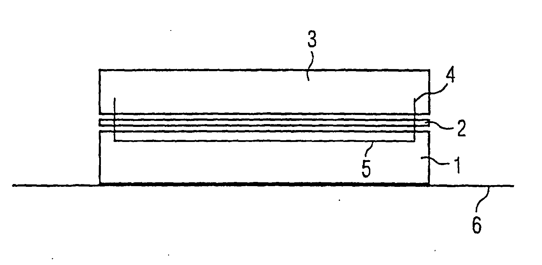

Es folgt eine Beschreibung von Beispielen der erfindungsgemäßen Abschirmvorrichtung anhand der beigefügten Figur. Diese Figur zeigt im Querschnitt ein SOI-Substrat mit einer erfindungsgemäß angeordneten Leiterstruktur.

Das SOI-Substrat (Silicon On Insulator) besteht aus einer Bulk-Siliziumschicht 1, die als Siliziumkörper denjenigen Bestandteil bildet, der das wesentliche Volumen des Substrates ausmacht, einer darauf aufgebrachten oder in dem Siliziumkörper ausgebildeten dünnen Isolatorschicht 2 und einer ebenfalls dünnen, vorzugsweise kristallinen Body-Siliziumschicht 3, in der die Halbleiterbauelemente der integrierten Schaltung ausgebildet sind. In der Figur sind die Dicken der Schichten nicht maßstabsgetreu dargestellt, da es nur auf die prinzipielle Anordnung der Schichten zueinander ankommt.

In der Figur sind mit vertikalen Strichen elektrisch leitende Durchkontaktierungen 4 dargestellt, die durch die Isolatorschicht 2 hindurch gehen und die Body-Siliziumschicht 3 mit der Bulk-Siliziumschicht 1 elektrisch verbinden. In der Body-Siliziumschicht 3 können diese Durchkontaktierungen 4 in einer beliebigen Weise an Komponenten einer in der Body-Siliziumschicht 3 integrierten Schaltung angeschlossen sein. Die Durchkontaktierungen 4 sind elektrisch leitend verbunden mit Leitern 5, die in der Bulk-Siliziumschicht 1, vorzugsweise in der Nähe der Isolatorschicht 2, angebracht sind. Diese elektrischen Leiter können als Leiterbahnen, die gitterartig oder doppelgitterartig strukturiert sein können, oder als Leiterflächen oder dergleichen ausgebildet sein. Diese Leiter 5 können bei der Herstellung des Substrates durch Implantation von Dotierstoff in das Halbleitermaterial der Bulk-Siliziumschicht 1 hergestellt werden. Es ist von Vorteil, wenn die Leiter 5 einen möglichst großen Bereich der Substratfläche bedecken. Das SOI-Substrat ist in diesem Beispiel auf einem Modulträger 6 montiert, der aber für die Erfindung nicht wesentlich ist.

Die Verwendung eines SOI-Substrates auch bei Halbleiterschaltungen, für die normalerweise kein SOI-Substrat vorgesehen wird, bewirkt, dass eine optische Inspektion mittels Rückseitenmikroskopie (Backside IR Microscopy) aufgrund der unterschiedlichen Brechungsindices des Halbleitermaterials und des Isolators nicht mehr möglich ist. Die Isolatorschicht bildet daher eine erfindungsgemäße Abschirmvorrichtung. In einem herkömmlichen Halbleitersubstrat oder speziell in der Bulk-Siliziumschicht eines SOI-Substrates, wie in dem beschriebenen Ausführungsbeispiel, können als Abschirmkomponenten elektrische Leiter vorgesehen werden; insbesondere können diese Leiter über vertikale elektrisch leitende Verbindungen, z. B. die beschriebenen Durchkontaktierungen, aktiv mit Komponenten der integrierten Schaltung angesteuert werden.

Bei Ausgestaltungen mit elektrischen Leitern als Abschirmvorrichtung auf der Substratseite des Halbleiterchips und elektrisch leitenden Verbindungen zwischen diesen Leitern und der integrierten Schaltung ist es insbesondere möglich, den Leitern der Abschirmvorrichtung Signalimpulse zuzuführen und mittels einer nachfolgenden Verifikation dieser zugeführten Signalimpulse eventuelle Manipulationen von der Rückseite des Substrates, d. h. in dem Ausführungsbeispiel mit SOI-Substrat von der Bulk-Siliziumschicht her, zu detektieren. Damit ist ein aktiver Rückseitenschirm (backside shield) realisiert.

Obwohl die Verwendung eines SOI-Substrates erfindungsgemäß bevorzugt ist, kann eine aktive Rückseitenabschirmung des Substrates auch bei einem herkömmlichen Substrat ohne Isolationsschicht vorgesehen werden. Ein solcher Schutzschirm wirkt im Prinzip wie ein aktiver Schutzschirm auf der Oberseite des IC-Chips.

### Bezugszeichenliste

- 1: Bulk-Siliziumschicht
- 2: Isolatorschicht
- 3: Body-Siliziumschicht
- 4: Durchkontaktierung
- 5: Leiter
- 6: Modulträger

## Patentansprüche

1. Abschirmvorrichtung für eine integrierte Schaltung in einem Halbleiterchip, der ein SOI-Substrat umfasst, bei der Mittel zur optischen und/oder elektrischen Abschirmung auf der dem Substrat zugewandten Seite der integrierten Schaltung in dem Halbleiterchip angeordnet sind,
die Mittel zur Abschirmung mindestens einen Leiter (5) in einer Bulk-Siliziumschicht (1) des SOI-Substrates umfassen, eine Durchkontaktierung (4) in einer Isolatorschicht (2) des Substrates vorhanden ist und
die Durchkontaktierung (4) den Leiter (5) mit einer Body-Siliziumschicht (3) des Substrates oder einem darin ausgebildeten Bauelement elektrisch leitend verbindet.

2. Abschirmvorrichtung nach Anspruch 1, bei der
der Leiter (5) ein Element aus der Gruppe von Leiterfläche, Leiterbahn, Leitergitter und Leiterdoppelgitter ist.

3. Abschirmvorrichtung nach Anspruch 1 oder 2, bei der
der Leiter (5) als dotierter Bereich in dem Substrat ausgebildet ist.

## Claims

1. Shielding device for an integrated circuit in a semiconductor chip which comprises an SOI substrate, in which means for optical and/or electrical shielding are arranged on the side of the integrated circuit in the semiconductor chip facing the substrate, the shielding means comprise at least one conductor (5) in a bulk silicon layer (1) of the SOI substrate,
a via (4) is present in an insulator layer (2) of the substrate, and
the via (4) electrically connects the conductor (5) to a body silicon layer (3) of the substrate, or to a component formed therein.

2. Shielding device according to Claim 1, in which the conductor (5) is an element from the group: conductor surface, conductor track, conductor grid and conductor double grid.

3. Shielding device according to Claim 1 or 2, in which the conductor (5) is formed as a doped region in the substrate.

## Revendications

1. Dispositif de blindage pour un circuit intégré d'une puce à semi-conducteurs, qui comprend un substrat SOI, dans lequel des moyens de blindage optique et/ou électrique sont disposés dans la puce à semi-conducteurs du côté du circuit intégré qui est tourné vers le substrat,
les moyens de blindage comprennent au moins un conducteur (5) dans une couche (1) de silicium bulk du substrat SOI,
il y a une métallisation (4) de trou dans une couche (2) isolante du substrat et,
la métallisation (4) de trou relie de manière conductrice de l'électricité le conducteur (5) à une couche (3) de silicium body du substrat ou à un composant constitué en son sein.

2. Dispositif de blindage suivant la revendication 1, dans lequel le conducteur (5) est un élément choisi dans le groupe de surface de conducteur, piste de conducteur, grille de conducteur et grille double de conducteur.

3. Dispositif de blindage suivant la revendication 1 ou 2, dans lequel le conducteur (5) est constitué sous la forme d'une partie dopé dans le substrat.
